(19) **Europäisches Patentamt**
**European Patent Office**
**Office européen des brevets**

(11) **EP 1 283 424 B1**

(12) **EUROPÄISCHE PATENTSCHRIFT**

(45) Veröffentlichungstag und Bekanntmachung des Hinweises auf die Patenterteilung:
**08.04.2009 Patentblatt 2009/15**

(51) Int Cl.:
**G01R 31/36** (2006.01)

(21) Anmeldenummer: **02013209.8**

(22) Anmeldetag: **15.06.2002**

(54) **Verfahren und Vorrichtung zur Bestimmung des Ladezustands einer Fahrzeugbatterie**

Procedure and device for determining the state of charge of a vehicle battery

Procédé et appareil de détermination de l'état de charge d'une batterie de véhicule

(84) Benannte Vertragsstaaten:
**DE ES FR GB IT SE**

(30) Priorität: **08.08.2001 DE 10139049**

(43) Veröffentlichungstag der Anmeldung:
**12.02.2003 Patentblatt 2003/07**

(73) Patentinhaber: **ROBERT BOSCH GMBH**
**70442 Stuttgart (DE)**

(72) Erfinder: **Bischoff, Claus**
**70469 Stuttgart (DE)**

(56) Entgegenhaltungen:
**DE-A- 19 964 057      US-A- 3 529 230**
**US-A- 5 191 291      US-A- 5 646 508**
**US-A- 5 761 072**

**Beschreibung**

Die Erfindung betrifft ein Verfahren und eine Vorrichtung zur Bestimmung des Ladezustands einer Fahrzeugbatterie.

Stand der Technik

In Kraftfahrzeuge werden zunehmend elektrische Verbraucher mit einer hohen Leistungsaufnahme integriert, beispielsweise im Zusammenhang mit Infotainment, Fahrer-Assistenzsystemen, usw.. Ein Teil dieser Verbraucher ist zur Realisierung von Funktionen vorgesehen, die für den Betrieb des Fahrzeugs sicherheitsrelevant sind. Dazu gehören unter anderem elektrische Lenkungssysteme und elektrohydraulische Bremsen. Ein sicherer Betrieb dieser Komponenten setzt eine stets betriebsbereite und ausreichend geladene Batterie im Bordnetz des Fahrzeugs voraus. Folglich ist es wünschenswert, eine zuverlässige und kostengünstige Ladezustandserkennung für eine in einem Kraftfahrzeug verwendete Batterie zur Verfügung zu haben.

Es ist bereits bekannt, mit Hilfe von mathematischen Modellen und Filterfunktionen eine Bestimmung des Anfangsladezustands einer Fahrzeugbatterie sowie eine Bestimmung des momentanen Ladezustands einer Fahrzeugbatterie durchzuführen. Unter Anfangsladezustand versteht man dabei den Ladezustand der Batterie nach einer Fahrzeug-Stillstandszeit. Eine Bestimmung des momentanen Ladezustands einer Fahrzeugbatterie ist insbesondere beim Vorliegen von niedrigen Außentemperaturen von Bedeutung. Eine derartige Bestimmung des Ladezustands einer Fahrzeugbatterie mit Hilfe von mathematischen Modellen und Filterfunktionen ist jedoch aufwendig und mit vergleichsweisen hohen Kosten verbunden.

In der Patentanmeldung 199 64 057.2 der Anmelderin ist ein Verfahren zur Erkennung einer defekten Kraftfahrzeug-Batterie beschrieben. Diese wird bei laufendem Motor von einem Generator auf einen von einem Steuergerät vorgegebenen Spannungssollwert aufgeladen und von einer elektrischen Last entladen. Weiterhin ist ein Spannungsmesser vorgesehen, der die Generator- oder die Batteriespannung kontinuierlich erfasst. Die Batteriespannung wird zunächst um einen definierten Wert erhöht und anschließend von einer Last des Bordnetzes um einen zweiten vorgegebenen Spannungswert entladen. Das Steuergerät ermittelt aus dem Spannungsgradienten einen Wert für den aktuellen Batteriezustand. Dabei wird von einer Tabelle Gebrauch gemacht, in welcher der Batteriezustand in Abhängigkeit vom Spannungsgradienten gespeichert ist. Diese Tabelle wurde zuvor in Abhängigkeit vom vorliegenden Batterietyp empirisch ermittelt.

Aus der US-A-5,191,291 wird eine konstante Stromlast zyklisch für eine bestimmte Zeitspanne an die Batterie angelegt. Anhand der Spannung wird überprüft, ob es sich um eine ordnungsgemäße Batterie handelt.

Aus der US-A-5,761,072 erfasst ein Mikroprozessor den Nettostrom einer Batterie. Daraus wird ein mittlerer Strom berechnet. Dieser wiederum wird integriert und in weiteren Berechnungen der Amperestunden-Kapazität berücksichtigt.

Aus der US-A-5,646,508 ist ein Prozessor vorgesehen, der Betriebs- und Arbeitsweise einer Batterie beobachtet. Entsprechende Daten werden in einem Speicher abgelegt, der sowohl durch die Batterie wie auch durch einen Kondensator gespeist werden kann.

Vorteile der Erfindung

Ein Verfahren und eine Vorrichtung gemäß der Erfindung weisen den Vorteil auf, dass durch die Verwendung gesteuerter E-Maschinen zur Erzeugung definierter Lastströme diese Lastströme sehr genau vorgegeben werden können. Dadurch kann der Anfangsladezustand der Fahrzeugbatterie vor einer Inbetriebnahme des Fahrzeugs mit hoher Genauigkeit ermittelt werden. Durch die Vorgabe eines definierten Stromprofils, was durch die Verwendung gesteuerter E-Maschinen realisiert wird, werden auch Umweltbedingungen berücksichtigt.

Die Erfindung beruht darauf, dass in steigendem Maße E-Maschinen mit hohem Leistungspotential in Kraftfahrzeugen eingesetzt werden, beispielsweise im Zusammenhang mit Starter-Generatoren und mit Hybridfahrzeugen. Diese E-Maschinen können bei geeigneter Ansteuerung zur Einstellung eines definierten Stromprofils verwendet werden. Der Zusatzaufwand für die Realisierung dieser Funktion ist gering, da der Strom und die Bordnetzspannung in diesen E-Maschinen ohnehin bereitgestellt und gemessen werden.

Liegt der genannte definierte Laststrom an der Batterie an, so bricht ihre Leerlaufspannung ein. Die Tiefe und der zeitliche Verlauf des Spannungseinbruchs stehen in direkter Abhängigkeit von der Batterietemperatur, dem genannten Laststrom und zum Ladezustand der Batterie.

In einem Fahrzeugsteuergerät ist ein Kennfeld hinterlegt, in welchem für unterschiedliche Umgebungstemperaturen und Ladezustände der Spannungsabfall und sein zeitlicher Verlauf für einen definierten Laststrom angegeben sind. Diese im Kennfeld abgespeicherten Daten werden nach Vorgabe des definierten Lastprofils mit dem aktuellen Spannungsabfall bei der aktuellen Umgebungstemperatur verglichen. Dieser Vergleich liefert eine Aussage über den Ladezustand der Batterie vor einer Inbetriebnahme des Fahrzeugs.

Zeichnung

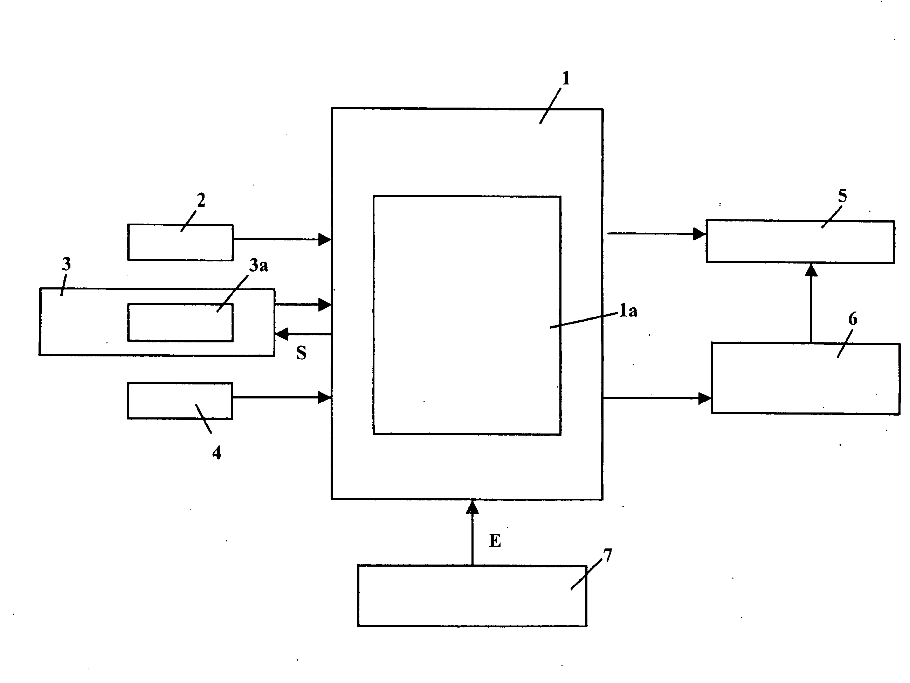

Nachfolgend wird anhand der Zeichnung ein Ausführungsbeispiel für die Erfindung näher erläutert. Die Figur zeigt ein Blockdiagramm mit den zum Verständnis der Erfindung wesentlichen Bestandteilen einer Vorrichtung zur Bestimmung des Ladungszustandes einer Fahrzeugbatterie.

Beschreibung

Die gezeigte Vorrichtung weist ein Fahrzeugsteuergerät 1 auf, in welchem ein Speicher 1a enthalten ist. In diesem Speicher 1a ist ein Kennfeld abgespeichert, welches im voraus empirisch im Rahmen von Laborversuchen ermittelt wurde. Bei diesen Versuchen wurden für unterschiedliche Umgebungstemperaturen und Ladezustände der Fahrzeugbatterie die Spannungsabfälle und deren zeitlicher Verlauf für einen definierten Laststrom ermittelt und daraus ein Kennfeld erstellt, welches einen Zusammenhang zwischen den genannten Parametern beschreibt:

$$ SOC_{Lx} \quad = \quad f \; (T_B, \; U_{CH}). $$

Dabei bezeichnet $SOC_{Lx}$ den Verlauf des Ladezustands bezogen auf einen definierten Laststrom Lx, beispielsweise 300 A. $T_B$ steht für die Batterietemperatur und $U_{CH}$ für eine den Spannungsabfall eindeutig beschreibende Charakteristik, wie unten noch näher erläutert wird.

Dieses abgespeicherte Kennfeld wird später zur Ermittlung des Ladezustands der Fahrzeugbatterie bei der jeweils aktuellen Umgebungstemperatur und dem definierten Lastprofil bzw. Laststrom verwendet. Dabei wird die bei der aktuellen Umgebungstemperatur und dem definierten Laststrom ermittelte Spannungscharakteristik mit den im Kennfeld abgespeicherten Daten verglichen und aus diesem Vergleich eine Aussage über den Ladezustand der Batterie abgeleitet.

Diese Vorgehensweise erlaubt eine Ermittlung des Ladezustands der Fahrzeugbatterie vor einer Inbetriebnahme des Fahrzeugs, d. h. eine Ermittlung des Anfangsladezustands der Fahrzeugbatterie.

Verfügt das jeweilige Fahrzeug über einen Sensor zur Bestimmung der Batterietemperatur und ein ausreichend stabiles Bordnetz, bei welchem kein starkes Spannungsgrundrauschen vorliegt, dann erlaubt diese Vorgehensweise es auch, im Fahrzeugbetrieb auf eine kontinuierliche Bestimmung des Ladezustands der Fahrzeugbatterie zu verzichten und lediglich vor einer Aktivierung von Funktionen wie einem elektrischen Fahren, einem Start-Stopp-Betrieb und einer Rekuperation eine derartige Ermittlung des Ladezustands der Batterie durch Anlegen eines definierten Laststromes und unter Verwendung des abgespeicherten Kennfeldes durchzuführen.

Alternativ dazu kann durch die beschriebene Vorgehensweise auch der Anfangsladezustand der Fahrzeugbatterie vor der Inbetriebnahme des Fahrzeug ermittelt und anschließend während des Fahrbetriebes durch zusätzliche Verwendung eines herkömmlichen Stromintegrationsverfahrens mit ausreichender Genauigkeit Aussagen über den momentanen Ladezustand der Fahrzeugbatterie gewonnen werden.

Soll der momentane Ladezustand der Fahrzeugbatterie mit hoher Genauigkeit ermittelt werden, dann kann dies unter Verwendung eines modellgestützten oder parametrisierten Stromintegrationsverfahrens erreicht werden. In diesem Fall kann die oben angegebene Vorgehensweise zur Ermittlung des Anfangsladezustands der Fahrzeugbatterie zu einem Parameterabgleich bei einem Motorstart oder während Stillstandszeiten eingesetzt werden, beispielsweise im Rahmen eines Start-Stopp-Betriebes.

Die Bestimmung des Anfangsladezustands der Fahrzeugbatterie geschieht bei dem in der Figur dargestellten Ausführungsbeispiel wie folgt:

In einem ersten Schritt erfolgt eine Aktivierung des Ladezustandsbestimmungsbetriebes. Diese Aktivierung erfolgt automatisch stets dann, wenn ein Entriegelungsdetektor 7 detektiert, dass das Fahrzeug vom Fahrer entriegelt wurde, und dem Fahrzeugsteuergerät 1 ein Entriegelungskennsignal E zugeführt hat.

Daraufhin übermittelt das Fahrzeugsteuergerät 1 einer oder mehreren E-Maschinen 3 des Fahrzeugs ein Steuersignal S, aufgrund dessen die E-Maschinen sprungartig den definierten Laststrom für die Fahrzeugbatterien abgeben. Liegt dieser definierte Laststrom an der Fahrzeugbatterie an, dann bricht deren Leerlaufspannung ein, wobei die Tiefe und der zeitliche Verlauf des Einbruchs der Leerlaufspannung in direkter Abhängigkeit von der Batterietemperatur, dem Laststrom und dem Ladezustand der Batterie stehen. Die Batterietemperatur des Fahrzeugs entspricht vor der Inbetriebnahme des Fahrzeugs der Umgebungstemperatur:

$$ T_{Umgebung} \quad = \quad T_B. $$

Liegt der definierte Laststrom an der Fahrzeugbatterie an, dann wird mittels der Spannungssensoren 3a der Pulswechselrichter der E-Maschinen 3 die Bordnetzspannung gemessen und daraus eine bordnetzspannungsabhängige Spannungscharakteristik abgeleitet, welche den Verlauf des Spannungseinbruchs an der Fahrzeugbatterie genau beschreibt.

Gemäß einer ersten Ausführungsform enthält diese Spannungscharakteristik Informationen über die Sprungantwort der Bordnetzspannung:

$$ U_{CH} \quad = \quad U_{SP}. $$

Dabei ist $U_{CH}$ die genannte Spannungscharakteristik und $U_{SP}$ die Sprungantwort des Bordnetzes auf eine Anregung mit dem Laststrom.

Gemäß einer zweiten Ausführungsform enthält die Spannungscharakteristik Informationen über einen Spannungsmittelwert der Bordnetzspannung nach Anregung mit dem Laststrom:

$$U_{CH} = \int_{t1}^{t2} U dt$$

Gemäß einer dritten Ausführungsform enthält die Spannungscharakteristik Informationen über einen Spannungssummenwert der Bordnetzspannung nach Anregung mit dem Laststrom:

$$U_{CH} = \sum_{i} U_i$$

Dabei wird durch i die Anzahl der Zeitschritte angegeben, an denen ein Wert zur Summenbildung erfasst wird.

Welche der vorstehenden Ausführungsformen zur Anwendung kommt, muss in Abhängigkeit vom jeweiligen konkreten Anwendungsfall entschieden werden. Wesentlich ist, dass durch die Spannungscharakteristik der jeweilige Spannungsabfall als Funktion vom Ladezustand der Batterie eindeutig identifizierbar ist.

Untersuchungen haben ergeben, dass bei einer Anwendung in einem Fahrzeug mit einer NiMH-Batterie NR 26/42V in einem Temperaturbereich T > -25°C und bei einem Laststrom von 300 A bei einer Ermittlung der Sprungantwort gute Ergebnisse erzielt werden. Folglich kann für diese Anwendung ein Kennfeld der Form

$$SOC_{300A} = f(T_B, U_{SP})$$

im Speicher 1a des Fahrzeugsteuergerätes hinterlegt werden.

Dieser Speicher 1a wird dann zur Ermittlung des Anfangsladezustands der Fahrzeugbatterie in Abhängigkeit von der aktuell ermittelten Spannungsscharakteristik und der aktuell gemessenen Außentemperatur adressiert, um aus dem abgespeicherten Kennfeld die zugehörige Ladezustandsinformation auszulesen. Dabei wurde die Information über die aktuell gemessene Außentemperatur dem Fahrzeugsteuergerät 1 vom Bordcomputer 2 des Fahrzeugs zugeführt. Diese aktuell gemessene Außentemperatur stimmt vor der Inbetriebnahme des Fahrzeugs mit der Batterietemperatur $T_B$ überein.

Soll im Sinne einer Weiterbildung der Erfindung über die Bestimmung des Anfangsladeszustands hinaus auch eine Ermittlung des momentanen Ladezustands der Fahrzeugbatterie während des Fahrbetriebes erfolgen oder soll eine Bestimmung des Ladezustands vor einer Aktivierung von Funktionen wie einem elektrischen Fahren, einem Start-Stopp-Betrieb oder einer Rekuperation erfolgen, dann wird die erforderliche Information über die Batterietemperatur $T_B$ von einem in der Batterie verbauten Temperaturfühler 4 abgeleitet.

Die im Fahrzeugsteuergerät 1 ermittelte Information über den Anfangsladezustand der Batterie wird dem Batteriemanagement 5 übermittelt, welches in Abhängigkeit von diesem Anfangsladezustand gegebenenfalls geeignete Schritte in die Wege leitet, beispielsweise eine Anzeige eines Ladezustandswertes oder eine Anzeige eines Alarmsignals dann, wenn der ermittelte Anfangsladezustand einen vorgegebenen Schwellenwert unterschreitet.

Soll unter Verwendung eines modellgestützten oder parametrisierten Stromintegrationsverfahrens eine hohe Genauigkeit aufweisende Messung des momentanen Ladezustands während des Fahrbetriebes erfolgen, dann wird die ermittelte Information über den Anfangsladezustand einem Schaltungsblock 6 zugeführt, in welchem eine derartige Ermittlung des momentanen Ladezustands der Batterie durchgeführt wird. Dabei kann - wie bereits oben angegeben wurde - der ermittelte Wert für den Anfangsladezustand zu einem Parameterabgleich bei einem Motorstart oder während der Stillstandszeiten im Rahmen eines Start-Stopp-Betriebes eingesetzt werden. Die ermittelte Information über den momentanen Ladezustand der Fahrzeugbatterie wird dann vom Schaltungsblock 6 aus dem Batteriemanagement 5 zugeführt.

**Patentansprüche**

1. Verfahren zur Bestimmung des Ladezustands einer Fahrzeugbatterie mit folgenden Schritten:

   - Aktivierung des Ladezustandsbestimmungsbetriebes,
   - Einstellung eines definierten Laststromes für die Fahrzeugbatterie durch Ansteuerung mindestens einer E-Maschine des Fahrzeugs,
   - Ableiten einer von der gemessenen Bordnetzspannung abhängigen Spannungscharakteristik,
   - Bereitstellung einer Information über die Batterietemperatur des Fahrzeugs, und
   - Ermittlung des Ladezustands der Fahrzeugbatterie unter Verwendung der Spannungscharakteristik, der Batterietemperatur und eines für den definierten Laststrom abgespeicherten Kennfeldes.

2. Verfahren nach Anspruch 1,
   **dadurch gekennzeichnet, dass**
   die Aktivierung des Ladezustandsbestimmungsbetriebes automatisch erfolgt.

3. Verfahren nach Anspruch 2,
   **dadurch gekennzeichnet, dass**

die Aktivierung des Ladezustandsbestimmungsbetriebes automatisch erfolgt, nachdem eine Fahrzeugentriegelung detektiert wurde.

4. Verfahren nach einem der vorhergehenden Ansprüche,
**dadurch gekennzeichnet, dass**
die Messung der Bordnetzspannung mittels der Spannungssensoren der Pulswechselrichter der E-Maschinen erfolgt.

5. Verfahren nach Anspruch 4,
**dadurch gekennzeichnet, dass**
die Spannungscharakteristik Informationen über die Sprungantwort der Bordnetzspannung aufweist.

6. Verfahren nach Anspruch 4,
**dadurch gekennzeichnet, dass**
die Spannungscharakteristik Informationen über einen Spannungsmittelwert der Bordnetzspannung aufweist.

7. Verfahren nach Anspruch 4,
**dadurch gekennzeichnet, dass**
die Spannungscharakteristik Informationen über einen Spannungssummenwert der Bordnetzspannung aufweist.

8. Verfahren nach einem der vorhergehenden Ansprüche,
**dadurch gekennzeichnet, dass**
als Information über die Batterietemperatur des Fahrzeugs eine vom Bordcomputer des Fahrzeugs abgeleitete Information über die Außentemperatur verwendet wird.

9. Verfahren nach einem der vorhergehenden Ansprüche,
**dadurch gekennzeichnet, dass**
das Kennfeld im Rahmen empirischer Messungen ermittelt und in einem Speicher des Fahrzeugs abgespeichert wird.

10. Verfahren nach Anspruch 9,
**dadurch gekennzeichnet, dass**
das ermittelte Kennfeld in einem Speicher eines Bordnetzsteuergerätes des Fahrzeugs abgespeichert wird.

11. Verfahren nach einem der vorhergehenden Ansprüche,
**dadurch gekennzeichnet, dass**
der ermittelte Ladezustand der Anfangsladezustand der Batterie vor einem Starten des Fahrzeugs, vor einer Aktivierung eines elektrischen Fahrens, bei einem Start-Stopp-Betrieb oder vor einer Rekuperation ist.

12. Verfahren nach einem der vorhergehenden Ansprüche,
**dadurch gekennzeichnet, dass**
während des Fahrbetriebes aus dem ermittelten Anfangsladezustand eine Ermittlung des momentanen Ladezustands der Fahrzeugbatterie unter zusätzlicher Verwendung eines Stromintegrationsverfahrens erfolgt.

13. Verfahren nach Anspruch 12,
**dadurch gekennzeichnet, dass**
das Stromintegrationsverfahren ein modellgestütztes oder parametrisiertes Stromintegrationsverfahren ist.

14. Verfahren nach einem der vorhergehenden Ansprüche,
**dadurch gekennzeichnet, dass**
der ermittelte Anfangsladezustand der Fahrzeugbatterie zum Parameterabgleich bei einem Motorstart oder während Stillstandszeiten des Fahrzeugs verwendet wird.

15. Vorrichtung zur Bestimmung des Ladezustands einer Fahrzeugbatterie, mit :

- mindestens einer ansteuerbaren E-Maschine (3) des Fahrzeugs, die in einem Ladezustandsbestimmungsbetrieb zur Abgabe eines definierten Laststromes an die Fahrzeugbatterie vorgesehen ist,
- Messmitteln (3a, 1) zur Messung der Bordnetzspannung nach Abgabe des genannten Laststromes,
- Mittel (3a) zum Ableiten einer von der gemessenen Bordnetzspannung abhängigen Spannungscharakteristik,
- Mittel (2, 4) zum Bereitstellen einer Information über die Batterietemperatur des Fahrzeugs,
- einem Speicher (1a) in welchem ein für den definierten Laststrom ermitteltes Kennfeld abgespeichert ist, und
- einer Steuereinheit (1), mittels derer der Ladezustand der Fahrzeugbatterie unter Verwendung der Spannungscharakteristik und der Batterietemperatur durch Adressierung.des Speichers (1a) ermittelt wird.

16. Vorrichtung nach Anspruch 15,
**dadurch gekennzeichnet, dass**
sie einen Entriegelungsdetektor (7) aufweist, dessen Ausgang mit der Steuereinheit (1) verbunden ist, dass die Steuereinheit dazu vorgesehen ist, der E-Maschine ein Ansteuersignal (S) zuzuführen, und dass die E-Maschine als Reaktion auf das Ansteuersignal (S) den definierten Laststrom an die Fahrzeugbatterie abgibt.

**17.** Vorrichtung nach Anspruch 15 oder 16, <u>**dadurch gekennzeichnet, dass**</u> die E-Maschine einen Pulswechselrichter aufweist und dass die Messmittel zur Messung der Bordnetzspannung dem Pulswechselrichter zugeordnete Spannungssensoren sind.

**18.** Vorrichtung nach einem der Ansprüche 15 - 17, <u>**dadurch gekennzeichnet, dass**</u> die Mittel zum Ableiten einer von der gemessenen Bordnetzspannung abhängigen Spannungscharakteristik einen Integrator oder einen Summierer aufweisen oder zur Ableitung der Sprungantwort des Bordnetzes auf die Anregung durch den definierten Laststrom vorgesehen sind.

**19.** Vorrichtung nach einem der Ansprüche 15 - 18, <u>**dadurch gekennzeichnet, dass**</u> sie einen Bordcomputer (2) aufweist, welcher der Steuereinheit (1) eine Information über die Außentemperatur des Fahrzeugs liefert.

**20.** Vorrichtung nach einem der Ansprüche 15 - 19, <u>**dadurch gekennzeichnet, dass**</u> der Speicher (1a) Bestandteil der Steuereinheit (1) ist.

**Claims**

**1.** Method for determining the charge state of a vehicle battery, comprising the following steps:

- activating the charge state determination mode,
- setting a defined load current for the vehicle battery by actuating at least one electrical machine of the vehicle,
- deriving a voltage characteristic which is dependent on the measured on-board electrical system voltage,
- providing information about the battery temperature of the vehicle, and
- establishing the charge state of the vehicle battery using the voltage characteristic, the battery temperature and a characteristic map which is stored for the defined load current.

**2.** Method according to Claim 1, **characterized in that** the charge state determination mode is automatically activated.

**3.** Method according to Claim 2, **characterized in that** the charge state determination mode is automatically activated after unlocking of the vehicle has been detected.

**4.** Method according to one of the preceding claims, **characterized in that** the on-board electrical system voltage is measured by means of the voltage sensors of the pulse-controlled inverters of the electrical machines.

**5.** Method according to Claim 4, **characterized in that** the voltage characteristic contains information about the step response of the on-board electrical system voltage.

**6.** Method according to Claim 4, **characterized in that** the voltage characteristic contains information about an average voltage value of the on-board electrical system voltage.

**7.** Method according to Claim 4, **characterized in that** the voltage characteristic contains information about a total voltage value of the on-board electrical system voltage.

**8.** Method according to one of the preceding claims, **characterized in that** information about the external temperature, which information is derived from the on-board computer of the vehicle, is used as information about the battery temperature of the vehicle.

**9.** Method according to one of the preceding claims, **characterized in that** the characteristic map is established on the basis of empirical measurements and is stored in a memory of the vehicle.

**10.** Method according to Claim 9, **characterized in that** the established characteristic map is stored in a memory of an on-board electrical system control device of the vehicle.

**11.** Method according to one of the preceding claims, **characterized in that** the established charge state is the initial charge state of the battery before the vehicle is started, before activation of driving by electric motor, during start/stop operation or before recuperation.

**12.** Method according to one of the preceding claims, **characterized in that** the momentary charge state of the vehicle battery is established, during driving, from the established initial charge state with the additional use of a current integration method.

**13.** Method according to Claim 12, **characterized in that** the current integration method is a model-assisted or parameterized current integration method.

**14.** Method according to one of the preceding claims, **characterized in that** the established initial charge state of the vehicle battery is used for adjusting parameters when the motor is started or during times at which the vehicle is stationary.

**15.** Apparatus for determining the charge state of a vehicle battery, comprising

- at least one actuable electrical machine (3) of the vehicle, which electrical machine is provided for outputting a defined load current to the vehicle battery during a charge state determination mode,
- measurement means (3a, 1) for measuring the on-board electrical system voltage after the said load current is output,
- means (3a) for deriving a voltage characteristic which is dependent on the measured on-board electrical system voltage,
- means (2, 4) for providing information about the battery temperature of the vehicle,
- a memory (1a) in which a characteristic map which is established for the defined load current is stored, and
- a control unit (1) by means of which the charge state of the vehicle battery is established using the voltage characteristic and the battery temperature by addressing the memory (1a).

**16.** Apparatus according to Claim 15, **characterized in that** it has an unlocking detector (7) whose output is connected to the control unit (1), **in that** the control unit is provided for the purpose of supplying an actuation signal (S) to the electrical machine, and **in that** the electrical machine outputs the defined load current to the vehicle battery in response to the actuation signal (S).

**17.** Apparatus according to Claim 15 or 16, **characterized in that** the electrical machine has a pulse-controlled inverter, and **in that** the measurement means for measuring the on-board electrical system voltage are voltage sensors which are associated with the pulse-controlled inverter.

**18.** Apparatus according to one of Claims 15-17, **characterized in that** the means for deriving a voltage characteristic which is dependent on the measured on-board electrical system voltage have an integrator or an adder or are provided for deriving the step response of the on-board electrical system to the stimulus provided by the defined load current.

**19.** Apparatus according to one of Claims 15-18, **characterized in that** it has an on-board computer (2) which supplies the control unit (1) with information about the external temperature of the vehicle.

**20.** Apparatus according to one of Claims 15-19, **characterized in that** the memory (1a) is a constituent part of the control unit (1).

**Revendications**

**1.** Procédé de détermination de l'état de charge d'une batterie de véhicule comprenant les étapes suivantes :

- activation du mode détermination de l'état de charge,
- réglage d'un courant de charge défini pour la batterie de véhicule en commandant au moins une machine électrique du véhicule,
- déduction d'une caractéristique de tension dépendante de la tension mesurée du réseau de bord,
- mise à disposition d'une information sur la température de la batterie du véhicule, et
- détermination de l'état de charge de la batterie du véhicule en utilisant la caractéristique de tension, la température de la batterie et un diagramme caractéristique mémorisé pour le courant de charge défini.

**2.** Procédé selon la revendication 1, **caractérisé en ce que** l'activation du mode détermination de l'état de charge s'effectue automatiquement.

**3.** Procédé selon la revendication 2, **caractérisé en ce que** l'activation du mode détermination de l'état de charge s'effectue automatiquement après avoir détecté un déverrouillage du véhicule.

**4.** Procédé selon l'une des revendications précédentes, **caractérisé en ce que** la mesure de la tension du réseau de bord est réalisée au moyen des détecteurs de tension de l'onduleur à impulsions des machines électriques.

**5.** Procédé selon la revendication 4, **caractérisé en ce que** la caractéristique de tension présente des informations sur la réponse transitoire de la tension du réseau de bord.

**6.** Procédé selon la revendication 4, **caractérisé en ce que** la caractéristique de tension présente des informations sur une valeur moyenne de la tension du réseau de bord.

**7.** Procédé selon la revendication 4, **caractérisé en ce que** la caractéristique de tension présente des informations sur une valeur totale de la tension du réseau de bord.

**8.** Procédé selon l'une des revendications précédentes, **caractérisé en ce que** l'information utilisée sur la température de la batterie du véhicule est une information sur la température extérieure dérivée de l'ordinateur de bord du véhicule.

**9.** Procédé selon l'une des revendications précédentes, **caractérisé en ce que** le diagramme caractéristique est déterminé dans le cadre de mesures empiriques et enregistré dans une mémoire du véhicule.

**10.** Procédé selon la revendication 9, **caractérisé en ce que** le diagramme caractéristique déterminé est enregistré dans une mémoire d'un module de commande du réseau de bord du véhicule.

**11.** Procédé selon l'une des revendications précédentes, **caractérisé en ce que** l'état de charge déterminé est l'état de charge initial de la batterie avant un démarrage du véhicule, avant une activation d'un déplacement électrique, lors d'un fonctionnement de type démarrage-arrêt ou avant une récupération.

**12.** Procédé selon l'une des revendications précédentes, **caractérisé en ce qu'**une détermination de l'état de charge momentané de la batterie du véhicule est effectuée pendant le déplacement à partir de l'état de charge initial déterminé en utilisant en plus un procédé d'intégration du courant.

**13.** Procédé selon la revendication 12, **caractérisé en ce que** le procédé d'intégration du courant est un procédé d'intégration du courant assisté par modèle ou paramétré.

**14.** Procédé selon l'une des revendications précédentes, **caractérisé en ce que** l'état de charge initial déterminé de la batterie du véhicule est utilisé pour l'équilibrage des paramètres lors d'un démarrage du moteur ou pendant les périodes d'immobilisation du véhicule.

**15.** Dispositif de détermination de l'état de charge d'une batterie de véhicule comprenant :

- au moins une machine électrique (3) commandable du véhicule, laquelle est prévue pour, dans un mode détermination de l'état de charge, pour délivrer un courant de charge défini à la batterie du véhicule,
- des moyens de mesure (3a, 1) pour mesurer la tension du réseau de bord après avoir délivré ledit courant de charge,
- des moyens (3a) pour déduire une caractéristique de tension dépendante de la tension mesurée du réseau de bord,
- des moyens (2, 4) pour mettre à disposition une information sur la température de la batterie du véhicule,
- une mémoire (1a) dans laquelle est enregistré un diagramme caractéristique déterminé pour le courant de charge défini, et
- une unité de commande (1) au moyen de laquelle est déterminé l'état de charge de la batterie du véhicule en utilisant la caractéristique de tension et la température de la batterie en adressant la mémoire (1a).

**16.** Dispositif selon la revendication 15, **caractérisé en ce qu'**il présente un détecteur de déverrouillage (7) dont la sortie est reliée avec l'unité de commande (1), que l'unité de commande est conçue pour acheminer à la machine électrique un signal de commande (S) et que la machine électrique délivre le courant de charge défini à la batterie du véhicule en réponse au signal de commande (S).

**17.** Dispositif selon la revendication 15 ou 16, **caractérisé en ce que** la machine électrique présente un onduleur à impulsions et que les moyens de mesure de la tension du réseau de bord sont des détecteurs de tension associés à l'onduleur à impulsions.

**18.** Dispositif selon l'une des revendications 15 à 17, **caractérisé en ce que** les moyens destinés à dériver une caractéristique de tension dépendante de la tension mesurée du réseau de bord présentent un intégrateur ou un additionneur ou sont prévus pour dériver la réponse transitoire du réseau de bord à l'excitation par le courant de charge défini.

**19.** Dispositif selon l'une des revendications 15 à 18, **caractérisé en ce qu'**il présente un ordinateur de bord (2) qui délivre à l'unité de commande (1) une information sur la température extérieure du véhicule.

**20.** Dispositif selon l'une des revendications 15 à 19, **caractérisé en ce que** la mémoire (1a) fait partie intégrante de l'unité de commande (1).

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 19964057 B
- US 5191291 A
- US 5761072 A
- US 5646508 A